# EUROPEAN PATENT APPLICATION

(11) **EP 4 628 987 A1**
(43) Date of publication of application: **08.10.2025**
(21) Application number: 25160677.8
(22) Date of filing: 27.02.2025
(51) Int. Cl.: G03F 1/24, G03F 1/38, G03F 1/60, G03F 1/54

(54) **PHOTOMASKS HAVING INTERMEDIATE BARRIER LAYERS**

(30) Priority: 28.03.2024 US 202418620107
(71) Applicant: INTEL Corporation, Santa Clara, CA 95054 (US)
(72) Inventor: KIM, Yongbae, San Jose, CA 95125 (US)
(74) Representative: HGF

(57) **Abstract**

Photomasks having intermediate barrier layers are disclosed. An example photomask comprises a substrate including a multilayer region, the multilayer region including alternating layers of a first material and a second material different from the first material, a capping layer, and an intermediate layer separating the capping layer and the substrate, the intermediate layer including a third material different from the first material and different from the second material.

## Description

### BACKGROUND

Semiconductor device fabrication includes various processes to manufacture integrated circuits or chips. Many processes involved in semiconductor device fabrication involve the use of photolithography. Photolithography involves the application of light onto a layer of light-sensitive material (e.g., photoresist, also sometimes referred to simply as a resist) in a controlled manner to produce a pattern in the layer of material in which portions of the layer of material are retained while other portions are removed. Often, the exposure of light onto a photoresist is controlled through the use of a photolithography mask (e.g., a photomask or simply mask).

### BRIEF DESCRIPTION OF THE DRAWINGS

FIG. 1 illustrates an example system that includes an example photomask to photolithographically pattern materials in an integrated circuit (IC) package.
FIG. 2 illustrates an example photomask constructed in accordance with teachings disclosed herein.
FIG. 3 is a flowchart representative of an example method of manufacturing the example photomask of FIG. 2 in accordance with teachings of this disclosure.
FIGS. 4A-4D illustrate various stages in an example process of fabrication of the example photomask of FIG. 2.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

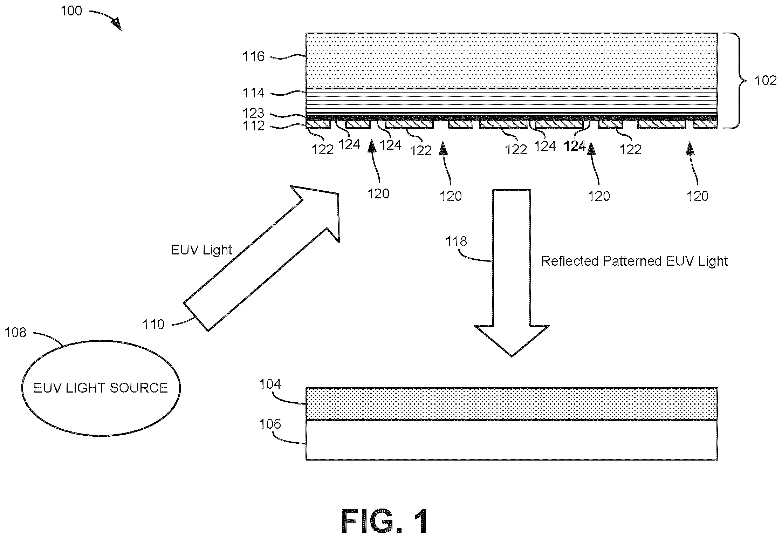

FIG. 1 illustrates an example system 100 that includes an example photomask 102 (or simply mask) to photolithographically pattern a layer of light-sensitive material (e.g., a photoresist) 104 on some underlying layer or substrate 106. In some instances, the underlying substrate 106 corresponds to a portion of an integrated circuit (IC) package. More particularly, in some instances, the underlying substrate 106 corresponds to a particular layer within a semiconductor die (e.g., an IC chip) within the IC package, a particular layer within a package substrate for the IC package, and/or any other suitable substrate. In some instances, the photoresist 104 is patterned to define openings in the photoresist 104 that can then be used as a mask to create corresponding openings in the underlying substrate 106 (e.g., through an etching process that removes portions of the underlying substrate exposed through the openings in the photoresist 104). In some instances, instead of removing portions of the underlying substrate 106 exposed through the openings in the photoresist 104, the openings in the photoresist 104 can be filled with a material to be added onto the underlying substrate 106 at the locations defined by the openings. In some instances, the photoresist 104 is removed after subsequent processing associated with the use of the patterned openings have been completed. In other instances, the photoresist 104 is retained on the underlying substrate 106 and remains as part of the final product (e.g., some portion of an IC package).

The system 100 of FIG. 1 is an extreme ultraviolet (EUV) lithography system. Accordingly, as shown in FIG. 1, the system 100 includes an EUV light source 108 that produces EUV light 110. More particularly, the EUV light source 108 can be a laser driven light source (e.g., based on tin plasma) that produces EUV light (e.g., ultraviolet light at a wavelength of approximately 13.5 nanometers (nm)). As shown in FIG. 1, the EUV light 110 is directed towards the photomask 102. The photomask 102 includes an absorber layer 112 (also referred to herein simply as an absorber) having a defined pattern on an outer surface of a multilayer region 114 (also referred to herein simply as a multilayer). The absorber 112 is an opaque material capable of absorbing the EUV light 110. In some examples, the absorber 112 is implemented with chromium. However, the absorber 112 can be implemented using any other suitable opaque material. The multilayer 114 is defined by a stack of thin films or layers of materials capable of reflecting the EUV light 110. More particularly, in some examples, the multilayer 114 includes alternating layers of molybdenum (Mo) and silicon (Si). As shown in FIG. 1, both the patterned absorber 112 and the multilayer 114 are carried by a support substrate 116. In some examples, the support substrate 116 is a solid piece of glass (e.g., a glass pane, panel, or sheet).

As the EUV light 110 reaches the photomask 102, the absorber 112 absorbs the EUV light 110. The reflective films within the multilayer 114 reflect at least a portion of the EUV light (referred to herein as reflected patterned EUV light 118) that is directed toward the photoresist 104. The reflected patterned EUV light 118 is defined by the pattern of the absorber 112. That is, as shown in FIG. 1, the pattern of the absorber 112 is defined by openings 120 between opaque regions 122 of the absorber 112. The opaque regions 122 absorb at least a portion of the EUV light 110 so that the absorbed portion of the EUV light 110 is not reflected towards the photoresist 104. The openings 120 expose portions of the underlying multilayer 114 and the exposed portions of the multilayer 114 will reflect at least a portion of the EUV light 110 (e.g., the reflected patterned EUV light 118) towards the photoresist 104.

In the illustrated example, the photoresist 104 is a photo-sensitive material such that the portions of the photoresist 104 exposed to the reflected patterned EUV light 118 will react to the light and change characteristics. Specifically, in some instances, the photoresist 104 exposed to light will harden such that when a developer solution is applied to the photoresist 104, the portions that remain relatively soft (e.g., the portions not exposed to the light) will be removed while the hardened portions will remain. In this manner the pattern defined by the opaque regions 122 of the absorber 112 on the photomask 102 are transferred to the photoresist 104. In other instances, the portions of the photoresist 104 exposed to the light 118 change so that they remain when a developer solution is applied while the rest of the photoresist 104 is removed. In this manner the pattern defined by the openings 120 in the absorber 112 (e.g., the inverse of the pattern defined by the opaque regions 122) is transferred to the photoresist 104.

As the EUV light 110 intensifies or the exposure to the EUV light 110 increases, the reflective capability of the photomask 102 can degrade. As such, the pattern provided on the photoresist 104 may include errors or defects. Typically, a capping layer 123 containing ruthenium (Ru) is provided on the multilayer 114 (e.g., via a sputtering process) to separate the absorber 112 and the multilayer region 114 of the photomask 102. In this way, the capping layer 123 can provide the reflective films within the multilayer 114 (e.g., surfaces 124 of the multilayer 114 associated with the openings 120) with at least some protection from the adverse effect of prolonged EUV light exposure.

However, the capping layer 123 is also susceptible to damage. For example, oxidants (e.g., hydroxyl (OH), oxygen (O), dioxygen (O₂), water (H₂O), etc.) and other chemical species may bond with the capping layer 123 and/or with the underlying materials in the multilayer 114 (e.g., if the capping layer 123 cannot block the out-diffusion of underlying materials or in-diffusion of the oxidants). In some examples, these oxidants may exist in an environment of the photomask 102 (e.g., in the presence of the EUV light source 108, in a storage facility separate from the EUV light source 108, etc.) such that the proximity of the oxidants to the capping layer 123 promote bonding and/or other chemical reactions. For example, the oxidants can permeate/diffuse through the capping layer 123 to react with the Si in the multilayer 114. In some examples, reactive chemical species can diffuse through the capping layer 123 and bond with the Si (e.g., forming SiO₂ via oxidation). Additionally or alternatively, the Si atoms under the capping layer 123 can out-diffuse and react with the oxidants to form SiO₂ around the diffusion paths in the capping material or on the capping layer 123. The resulting SiO₂ damages the capping layer 123 and, thus, degrades and/or reduces the reflective capability of the photomask 102.

Examples disclosed herein provide photomasks with an example intermediate barrier layer that separates a capping layer from a multilayer region to prevent diffusion and/or other chemical reactions. In particular, example intermediate barrier layers disclosed herein can limit and/or prevent the diffusion (e.g., out diffusion) of Si from such a multilayer region toward the capping layer (e.g., oxidants on the capping layer). Likewise, example intermediate barrier layers disclosed herein can limit and/or prevent the diffusion of external oxidants from reaching and, thus, reacting with the multilayer region. As such, examples disclosed herein limit and/or eliminate formation of SiO₂ and/or other harmful molecules by providing an intermediate barrier layer between the capping layer and the multilayer region. Examples disclosed herein protect the reflective surfaces (e.g., the surface 124) associated with photomasks from the detrimental effects of oxidants, diffusion, chemical reactions, etc. Accordingly, examples disclosed herein extend the life (e.g., expected, iterative use) of photomasks under EUV light.

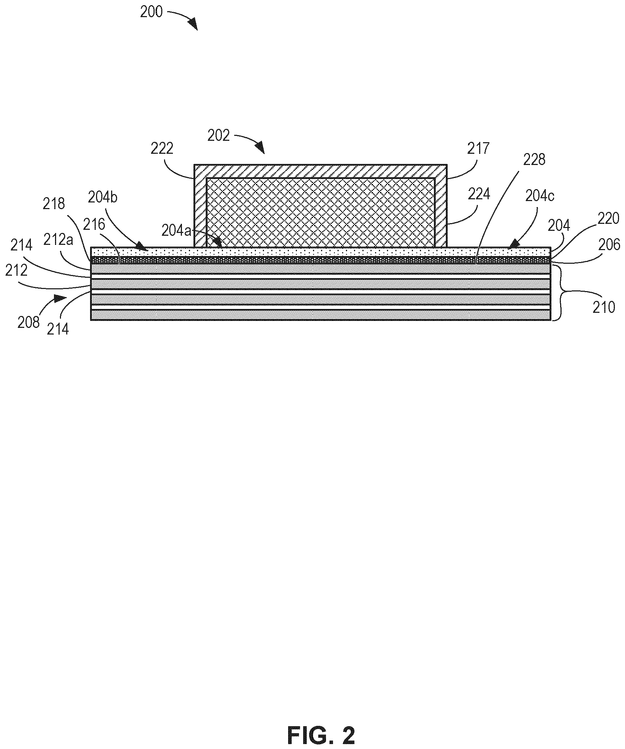

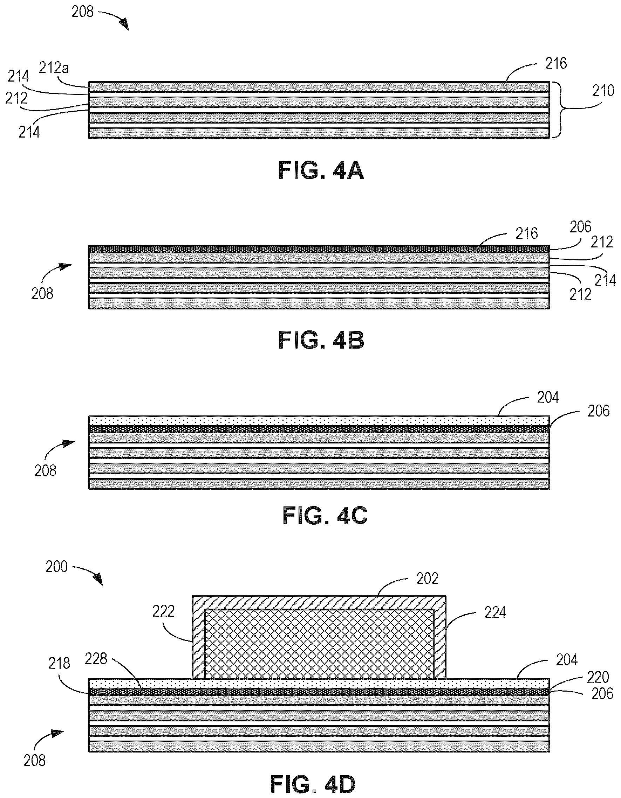

FIG. 2 is a cross-sectional view of an example photomask 200. The example photomask 200 of FIG. 2 may be manufactured according to the example manufacturing process illustrated in stages in FIGS. 4A-4D. In some examples, the photomask 200 may be implemented in the system 100 of FIG. 1 to photolithographically pattern a layer of light-sensitive material (e.g., the photoresist 104) on some underlying layer or substrate. The example photomask 200 includes an example absorber 202, an example capping layer 204, an example intermediate barrier layer 206, and an example substrate 208 (e.g., a photomask substrate) having an example multilayer region 210. In some examples, the multilayer region 210 of the example substrate 208 is supported by and/or carried on a separate, underlying substrate (e.g., the support substrate 116 of FIG. 1) to provide rigidity and mechanical integrity to the photomask 200. The example multilayer region 210 includes alternating layers of a first example material 212 and a second example material 214 different from the first material 212. In some examples, the first material 212 includes Si (e.g., Si layers 212) and the second material 214 includes Mo (e.g., Mo layers 214). In some examples, the multilayer region 210 can include any number of pairs of the first material 212 and the second material 214 (e.g., 40 pairs, 50 pairs, etc.).

The example intermediate barrier layer 206 includes a third material different from the first material 212 and different from the second material 214. In some examples, the intermediate barrier layer 206 includes nitrogen (N). For example, the intermediate barrier layer 206 can include at least one of silicon nitride (SiN), titanium nitride (TiN), or tantalum nitride (TaN). Thus, in some examples, the intermediate barrier layer 206 includes N and at least one of Si, titanium (Ti), or tantalum (Ta). As used herein, the terms "intermediate barrier layer," "intermediate layer," and "barrier layer" are used interchangeably to refer to a material, a layer, etc., separating the substrate 208 from the capping layer 204. In some examples, the intermediate barrier layer 206 is in contact with (e.g., contacts) a first example layer 212a (e.g., an outermost layer) of the first material 212 in the multilayer region 210. As shown in FIG. 2, the first layer 212a of the first material 212 defines (e.g., provides) an example side 216 (e.g., an outer surface) of the substrate 208. Thus, the intermediate barrier layer 206 can contact the (outer) side 216 of the substrate 208. Further, the intermediate barrier layer 206 separates the first layer 212a (e.g., including Si) from the capping layer 204. In some examples, the intermediate barrier layer 206 replaces (e.g., is substituted for) the first layer 212a. As such, the intermediate barrier layer 206 can contact an outermost layer of the second material 214 of the multilayer region 210. In some examples, the first layer 212a includes a first thickness (e.g., in a range from 2nm to 5nm) and the intermediate barrier layer 206 includes a second thickness substantially equal to (e.g., within 0.5 nm) the first thickness. In some examples, the intermediate barrier layer 206 includes a thickness in a range from 0.5 nm to 5 nm. In some examples, layers of the first material 212 include a thickness in a range from 3 nm to 5 nm. In some examples, layers of the second material 214 include a thickness in a range from 2 nm to 4 nm. In some examples, the capping layer 204 includes a thickness in a range from 1 nm to 4 nm.

The capping layer 204 can be positioned on the intermediate barrier layer 206. In particular, the capping layer 204 can cover the intermediate barrier layer 206. As shown in FIG. 2, the capping layer 204 separates the intermediate barrier layer 206 from the absorber 202. Put differently, the absorber 202 is positioned on the capping layer 204. The absorber 202 represented in the illustrated example of FIG. 2 corresponds to a single opaque region (e.g., one of the opaque regions 122 of FIG. 1) in a pattern that extends across the full surface of the photomask 200 (only part of which is shown in FIG. 2). The absorber 202 can include an example native oxide layer 217 (e.g., Ta₂O₅) that at least partially covers a body of the absorber 202. Further, a material of the absorber 202 can include tantalum nitride (TaN).

The absorber 202 can be positioned on a first portion 204a of the capping layer 204. In the example of FIG. 2, the first portion 204a of the capping layer 204 is positioned between a second portion 204b and a third portion 204c of the capping layer 204. In this example, the second and third portions 204b, 204c of the capping layer 204 correspond to openings (e.g., the openings 120 of FIG. 1) in the patterned absorber that otherwise extends across the surface of the photomask 200. Further, as shown in this example, the intermediate barrier layer 206 separates at least one of the first portion 204a or the second portion 204b of the capping layer 204 from the substrate 208. Example ends 218, 220 (e.g., edges) of the intermediate barrier layer 206 extend beyond opposing sides 222, 224 of the absorber 202 (e.g., the discrete portion of the absorber 202 shown in FIG. 2 corresponding to an opaque region 122 in a pattern provided along a surface 228 of the substrate 208). In some examples, additional absorbers (e.g., other opaque regions 122 of the overall absorber pattern) may be positioned on the capping layer 204. In such examples, the intermediate barrier layer 206 can extend along the surface 228 of the substrate 208 from the absorber 202 to be aligned to (e.g., positioned under) at least one other additional absorber.

The example capping layer 204 includes Ru to at least partially protect the multilayer region 210 from the deleterious effects of prolonged EUV light exposure (e.g., the EUV light 110 from the EUV light source 108). As previously mentioned, oxidants bonded to the capping layer 204 are prone to bond with elements included in the substrate 208 (e.g., Si, Mo, etc.). However, the chemical makeup of the example intermediate barrier layer 206 (e.g., including N) provides a physical blockade/obstruction that prevents elements of the substrate 208 from diffusing towards the capping layer 204 and/or prevents oxidants on the capping layer 204 from diffusing towards the substrate 208. As such, the intermediate barrier layer 206 isolates the oxidants from the Si and the Mo which, in turn, limits or prevents the formation of SiO₂ and/or other molecules. As such, the intermediate barrier layer 206 included in the photomask 200 defends the integrity of the reflective films in the multilayer region 210.

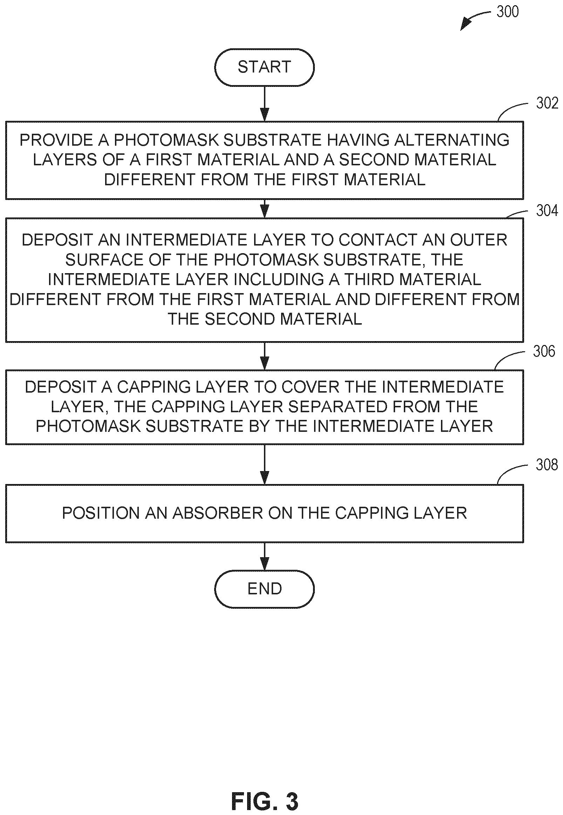

FIG. 3 is a flowchart representative of an example method 300 to manufacture the example photomask 200 of FIG. 2. FIGS. 4A-4D represent the example photomask 200 at various stages during the example method 300 described in FIG. 3. In some examples, some or all of the operations outlined in the example method of FIG. 3 are performed automatically by fabrication equipment that is programmed to perform the operation. Although the example method of manufacture is described with reference to the flowchart illustrated in FIG. 3, many other methods may alternatively be used. For example, the order or execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

Turning to FIG. 3, the example process begins at block 302, at which an example photomask substrate having alternating layers of a first material and a second material is provided, the second material different from the first material. As shown in FIG. 4A, the example substrate 208 is provided. The example substrate 208 includes the multilayer region 210 having alternating layers of the first material 212 and the second material 214. Further, in this example, the first layer 212a of the first material 212 defines the side 216 of the substrate 208. In other examples, where the barrier layer 206 is to replace the outermost layer of the first material 212, the outermost layer of the substrate 208 is the second material 214.

At block 304, an example intermediate layer is deposited to contact an outer surface of the photomask substrate, the intermediate layer includes a third material different from the first material and different from the second material. As shown in FIG. 4B, the intermediate barrier layer 206 is deposited to contact the side 216 (e.g., the outer surface) of the substrate 208. The example intermediate layer 206 includes a third material (e.g., including N) different from the first material 212 (e.g., including Si) and different from the second material 214 (e.g., including Mo).

At block 306, an example capping layer is deposited to cover the intermediate layer, the capping layer separated from the photomask substrate by the intermediate layer. As shown in FIG. 4C, the capping layer 204 is deposited to cover the intermediate layer 206. Further, the capping layer 204 is separated from the substrate 208 by the intermediate layer 206.

At block 308, an example absorber is positioned on the capping layer. As shown in FIG. 4D, the absorber 202 is positioned on the capping layer 204. In this example, the absorber 202 represents an opaque region 122 of an overall pattern that includes openings 120 between the opaque regions. Thus, in this example, the ends 218, 220 of the intermediate layer 206 extend beyond the opposing sides 222, 224 of the absorber 202 (e.g., along the surface 228 of the substrate 208). Then, the process ends.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

From the foregoing, it will be appreciated that example systems, apparatus, articles of manufacture, and methods have been disclosed that provide photomasks with an example intermediate barrier layer to separate a capping layer from a multilayer region to prevent diffusion or other chemical reactions. In particular, example intermediate barrier layers disclosed herein can limit and/or prevent the diffusion (e.g., out diffusion) of Si from such a multilayer region toward the capping layer and/or prevent diffusion of oxidants external to the capping layer from reaching the multilayer region. As such, examples disclosed herein limit and/or eliminate formation of SiO₂ and/or other harmful molecules by providing an intermediate barrier layer between the capping layer and the multilayer region. Examples disclosed herein protect the reflective surfaces associated with photomasks from the detrimental effects of oxidants, diffusion, chemical reactions, etc. Accordingly, examples disclosed herein extend the life of photomasks under EUV light.

Example 1 includes a photomask comprising a substrate including a multilayer region, the multilayer region including alternating layers of a first material and a second material different from the first material, a capping layer, and an intermediate layer separating the capping layer and the substrate, the intermediate layer including a third material different from the first material and different from the second material.

Example 2 includes the photomask of example 1, wherein the first material includes silicon and the second material includes molybdenum.

Example 3 includes the photomask of any one of examples 1 or 2, wherein the intermediate layer is in contact with a layer of the substrate including the first material.

Example 4 includes the photomask of any one of examples 1-3, wherein the layer of the substrate includes a first thickness and the intermediate layer includes a second thickness, the second thickness substantially equal to the first thickness.

Example 5 includes the photomask of any one of examples 1-4, further including an absorber positioned on the capping layer.

Example 6 includes the photomask of example 5, wherein the absorber is positioned on a first portion of the capping layer, the first portion positioned between second and third portions of the capping layer, the intermediate layer separating at least one of the second portion or the third portion from the substrate.

Example 7 includes the photomask of any one of examples 5 or 6, wherein the intermediate layer extends along a surface of the substrate, ends of the intermediate layer to extend beyond opposing sides of the absorber.

Example 8 includes the photomask of any one of examples 1 or 2, wherein the intermediate layer is in contact with a layer of the substrate including the second material.

Example 9 includes the photomask of any one of examples 1-8, wherein the third material includes nitrogen.

Example 10 includes the photomask of example 9, wherein the third material includes silicon.

Example 11 includes the photomask of example 9, wherein the third material includes titanium.

Example 12 includes the photomask of example 9, wherein the third material includes tantalum.

Example 13 includes the photomask of any one of examples 1-12, wherein the intermediate layer is to prevent elements of the substrate from diffusing towards the capping layer.

Example 14 includes an apparatus comprising alternating layers of a first material and a second material, a barrier layer in contact with a first layer of the first material, the barrier layer including nitrogen, and a capping layer positioned on the barrier layer, the barrier layer separating the capping layer from the first layer of the first material.

Example 15 includes the apparatus of example 14, wherein the first material includes silicon, the second material includes molybdenum, and the capping layer includes ruthenium.

Example 16 includes the apparatus of any one of examples 14 or 15, further including an absorber, the capping layer separating the absorber from the barrier layer.

Example 17 includes the apparatus of any one of examples 14-16, wherein the barrier layer includes a thickness in a range from 0.5 nanometers (nm) to 5 nm.

Example 18 includes the apparatus of any one of examples 14-17, wherein the barrier layer includes at least one of silicon, titanium, or tantalum.

Example 19 includes a method comprising providing a photomask substrate, the photomask substrate having alternating layers of a first material and a second material different from the first material, depositing an intermediate layer to contact an outer surface of the photomask substrate, the intermediate layer including a third material different from the first material and different from the second material, and depositing a capping layer to cover the intermediate layer, the capping layer separated from the photomask substrate by the intermediate layer.

Example 20 includes the method of example 19, further including positioning an absorber on the capping layer.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A photomask comprising:
a substrate including a multilayer region, the multilayer region including alternating layers of a first material and a second material different from the first material;
a capping layer; and
an intermediate layer separating the capping layer and the substrate, the intermediate layer including a third material different from the first material and different from the second material.

2. The photomask of claim 1, wherein the first material includes silicon and the second material includes molybdenum.

3. The photomask of claim 2, wherein the intermediate layer is in contact with a layer of the substrate including the first material.

4. The photomask of claim 3, wherein the layer of the substrate includes a first thickness and the intermediate layer includes a second thickness, the second thickness substantially equal to the first thickness.

5. The photomask of any one of claims 1-4, further including an absorber positioned on the capping layer.

6. The photomask of claim 5, wherein the absorber is positioned on a first portion of the capping layer, the first portion positioned between second and third portions of the capping layer, the intermediate layer separating at least one of the second portion or the third portion from the substrate.

7. The photomask of any one of claims 5 or 6, wherein the intermediate layer extends along a surface of the substrate, ends of the intermediate layer to extend beyond opposing sides of the absorber.

8. The photomask of any one of claims 1-7, wherein the intermediate layer is in contact with a layer of the substrate including the second material.

9. The photomask of any one of claims 1-8, wherein the third material includes nitrogen.

10. The photomask of any one of claims 1-9, wherein the intermediate layer is to prevent elements of the substrate from diffusing towards the capping layer.

11. The apparatus of any one of claims 1-10, wherein the capping layer includes ruthenium.

12. The apparatus of any one of claims 1-11, wherein the barrier layer includes a thickness in a range from 0.5 nanometers (nm) to 5 nm.

13. The apparatus of any one of claims 1-12, wherein the barrier layer includes at least one of silicon, titanium, or tantalum.

14. A method comprising:
providing a photomask substrate, the photomask substrate having alternating layers of a first material and a second material different from the first material;
depositing an intermediate layer to contact an outer surface of the photomask substrate, the intermediate layer including a third material different from the first material and different from the second material; and
depositing a capping layer to cover the intermediate layer, the capping layer separated from the photomask substrate by the intermediate layer.

15. The method of claim 14, further including positioning an absorber on the capping layer.
